# EUROPEAN PATENT APPLICATION

(11) **EP 0 578 915 A2**
(43) Date of publication of application: **19.01.1994**
(21) Application number: 93103984.6
(22) Date of filing: 11.03.1993
(51) Int. Cl.: G11C 8/00

(54) **Two-port ram cell**

(30) Priority: 16.07.1992 US 914715
(71) Applicant: Hewlett-Packard Company, Palo Alto, California 94304 (US)
(72) Inventor: Talley,Harlan A., Vancouver,WA 98664 (US); Beucler, Dale, Fort Collins, CO 80526 (US)
(74) Representative: Schoppe, Fritz, Dipl.-Ing.

(57) **Abstract**

A two-port RAM cell includes a data storage component comprising first and second NFETs Q1, Q2 connected to first and second PFETs Q3, Q4. The cell also includes a first read/write port, comprising complementary terminals BITA and NBITA connected to first and second transfer PFETs Q7, Q8, and a second read/write port, comprising complementary terminals BITB and NBITB coupled to first and second transfer NFETs Q5, Q6. Each of the P-channel FETs Q3, Q4, Q7 and Q8 is formed in an N-well region of the substrate.

## Description

### Field of the Invention

The present invention generally relates to random access memory (RAM), and more particularly relates to a CMOS two-port RAM cell that can be employed in a two-port RAM array using a conventional manufacturing process.

### Background of the Invention

MOS field effect transistors can be classified as P-channel and N-channel transistors. P-channel field effect transistors (PFETs) use holes as their dominant current carrier. N-channel field effect transistors (NFETs) use electrons as their dominant current carrier. NFETs and PFETs can be further divided into enhancement-mode transistors and depletion-mode transistors. The enhancement-mode transistor acts as a switch and is turned on or off by adjusting the voltage on the gate node above or below a threshold voltage. The depletion-mode transistor has its threshold adjusted so that it is always on and is generally used as an active load.

In accordance with the above definitions, MOS integrated circuits (ICs) can be divided into PMOS ICs, NMOS ICs, and CMOS ICs. PMOS ICs contain only enhancement-mode PFETs and/or depletion-mode PFETs. NMOS ICs contain only enhancement-mode NFETs and/or depletion-mode NFETs. CMOS ICs contain both enhancement-mode NFETs and enhancement-mode PFETs. CMOS ICs provide both speed and power advantages over PMOS and NMOS ICs. The present invention is primarily concerned with CMOS RAMs.

The memory cells used in RAMs can be classified as static cells or dynamic cells. Static cells (and static RAMs) use some form of latched storage (such as a flip-flop), while dynamic cells dynamically store charge on a capacitor. Static cells are easier to design and are typically less troublesome than dynamic cells, and do not require periodic refresh to retain the data. In addition, static cells tend to be faster than dynamic cells.

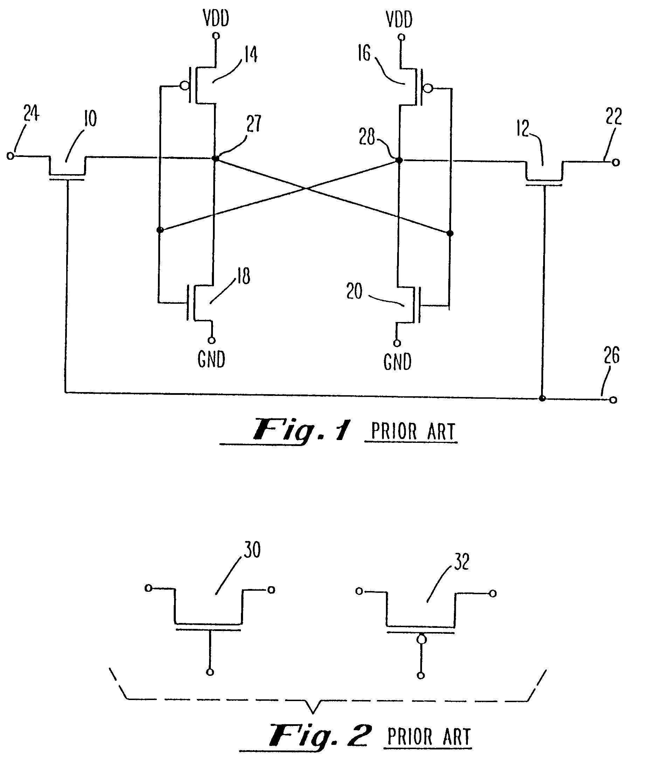

Figure 1 schematically shows a prior art single-port RAM cell. This cell comprises first and second transfer NFETs 10, 12, first and second P-channel FETs (pull-up FETs) 14, 16, and first and second N-channel FETs 18, 20. (Polysilicon resistors are often used as pull-up devices. This is because RAM makers tune their IC processes to minimize cell area, and polysilicon resistors can be made smaller than transistors; however, general purpose CMOS processes do not have resistors with high enough impedance and therefore must employ transistor pull-ups.) Each of the PFETs 14, 16 is a load device for counteracting the effect of charge leakage to or from its associated pull-down and transfer transistors. Terminals 22 and 24 provide a read/write port through which a binary digit may be stored in or read from the cell. Terminal 26 provides means for selecting the cell in connection with a read or write operation.

Figure 2 depicts the symbols employed in this specification (and often in industry) to represent an NFET (reference number 30) and a PFET (reference number 32).

Referring to Figure 1, a cell is selected by raising the voltage on its "row" line (or "select" line) 26. NFETs 10 and 12 serve as gates for the "bit" lines (or "digit" lines) 24, 22. NFETs 18 and 20, along with pull-up PFETs 14 and 16, form a cross-coupled flip-flop. The state of the storage cell can be read by raising the voltage on the row line 26, which will allow current to flow through either NFET 10 or 12 and its associated pull-down FET 18 or 20, depending on the state of the cell (i.e., depending on the voltage on nodes 27 and 28). A read operation commences by precharging the bit lines 22, 24. The row line 26 is asserted and either line 22 or line 24 will be discharged through one of the pull-down transistors 18, 20. The voltage on lines 22 and 24 is monitored, e.g., with a sense amp comprising a differential amplifier, to determine the state of the cell. An alternative to using precharge is to use static pull-ups on the bit lines.

A write operation is carried out by raising the voltage of the row line 26 and setting the desired state of the cell by appropriately placing a high voltage on either bit line 22 or 24 and a low voltage on the other bit line. For example, assume that a "0" is stored at node 27 and a "1" is stored at node 28 and that we wish to switch the state of the cell such that a "1" is stored at node 27 and a "0" is stored at node 28. Terminal 24 should be set to "1" (VDD), terminal 22 should be set to "0" and row line 26 should be set to "1." The driven bit lines will then overpower the cell. The cross-coupled inverter pair will thus become unbalanced and feedback will cause the cell to change its state.

As described in this specification, a RAM cell is a one-bit memory element. A RAM is an array of RAM cells with associated control and address logic. A RAM port comprises an address input, which determines the location of the RAM cells to be read or written, a data input bus for data to be written, and a data output bus for read data returned from the RAM. A RAM port may exclude a data input, in which case it would be a read-only port, or may exclude a data output, in which case it would be a write-only port.

A single-port RAM allows only one read or write at a time through a single port; in contrast, a two-port RAM allows simultaneous reads and/or writes through two separate and independent ports. The RAM cells used in a two-port RAM must have two separate and independent ports.

Two-port RAM cells may be divided into those that can be fabricated with general purpose processes, such as those conventionally used for fabricating microprocessors, controllers, RAMDACs, and other application-specific integrated circuits, and those requiring special devices not available from general purpose processes, such as stacked FETs and high-resistance diffused resistors.

RAM cells may be further divided into cells with single-ended outputs and cells with differential outputs. A cell with a single-ended output supplies a single low-level signal which must be amplified to produce a logical zero or one. While such a cell can be made very compact, it requires that the RAM include a complex single-ended sense amplifier. Even with a well-designed sense amplifier, a single-ended RAM is more sensitive to noise than a RAM using cells with a differential output.

A cell with a differential output supplies two signals whose difference is amplified to produce a logical "0" or "1." Known differential output RAM cells that are intended for use with a general purpose process have two transfer FETs for each port, where all of the transfer FETs are N-channel devices. Such a cell is an extension of the single-port cell with a differential output.

A two-port RAM cell implemented with a general purpose IC process is typically larger than desirable, for a given speed. For this reason, many RAM chip processes in industry are customized to minimize cell area. The present invention provides a variation of the prior art two-port RAM cell that leads to a compact layout in a general purpose IC manufacturing process.

### Summary of the Invention

A primary object of the present invention is to provide a two-port RAM cell that has a differential output and can be employed with general purpose processes. A preferred embodiment of a RAM cell in accordance with the present invention employs P-channel devices for the transfer FETs of one of the ports. Although this is not a logical extension of the single-port RAM cell, it offers a number of advantages over two-port RAM cells of the prior art. Moreover, because of the limited number of connection layers available in a general-purpose process and because of the large space required between N-channel and P-channel devices (because of the presence of an N-well), this cell can be laid out much more compactly than prior art cells.

Two-port RAM cells (and RAM arrays) in accordance with the present invention comprise: a substrate, a data storage element formed in the substrate, a first differential port means, and a second differential port means comprising first and second transfer PFETs formed in the substrate.

In specific embodiments of the invention, the first differential port means comprises first and second transfer NFETs.

Embodiments of the invention also comprise first interconnecting means for interconnecting the gate of the first transfer PFET and the gate of the second transfer PFET; second interconnecting means for interconnecting the gate of the first transfer NFET and the gate of the second transfer NFET; third interconnecting means for interconnecting the source of the first transfer PFET, the gate of the first PFET, the gate of the first NFET, the source of the first transfer NFET, the source of the second PFET, and the drain of the second NFET, and fourth interconnecting means for interconnecting the source of the second transfer PFET, the gate of the second PFET, the gate of the second NFET, the source of the second transfer NFET, the source of the first PFET, and the drain of the first NFET.

Preferred embodiments of the invention comprise an N-well of N-type material diffused into the substrate. In these embodiments the first and second PFETs and the first and second transfer PFETs are formed in the N-well.

Preferred embodiments also comprise a first terminal (labelled ROWA in the drawings) connected to the first interconnecting means, a second terminal (ROWB) connected to the second interconnecting means, a third terminal (BITA) connected to the drain of the second transfer PFET, a fourth terminal (NBITA) connected to the drain of the first transfer PFET, a fifth terminal (BITB) connected to the drain of the second transfer NFET, and a sixth terminal (NBITB) connected to the drain of the first transfer NFET.

A binary digit (bit) may be written (via port A) to the RAM cell by setting the third terminal (BITA) to a high potential for a binary "1" or a low potential for a binary "0" while holding the first terminal (ROWA) and the second terminal (ROWB) to a low potential; alternatively, a bit may be written to the cell by setting the fifth terminal (BITB) to a high potential for a binary "1" or a low potential for a binary "0" while holding the first terminal and the second terminal to a high potential. A read or write to port A requires ROWA to go low (ROWA is negative true), whereas a read or write to port B requires ROWB to go high (ROWB is positive true). A previously-written bit may be read by precharging the third terminal (BITA) and the fourth terminal (NBITA) to a high potential, setting the first terminal (ROWA) to a low potential, and monitoring the difference in the potentials of the third and fourth terminals (BITA, NBITA); alternatively, a previously-written bit may be read from the cell by precharging the fifth terminal (BITB) and the sixth terminal (NBITB) to a high potential, setting the second terminal (ROWB) to a high potential and monitoring the difference in the potentials of the fifth and sixth terminals (BITB, NBITB).

Thus, preferred embodiments of a two-port RAM cell in accordance with the present invention comprise two differential read/write ports, each comprising a pair of transfer FETs, or gates. One FET of each pair is connected to a "true" (in a digital logic sense) terminal of the cell (e.g., BITA) and the other FET of each pair is connected to a terminal (e.g., NBITA) that is complementary to a corresponding true terminal. One of the said pairs of transfer FETs comprises PFETs and the other pair comprises NFETs, in contrast to prior art two-port RAM cells that use NFETs for all four transfer FETs or that have single-ended outputs (i.e., only one transfer FET per port). The present invention offers greater layout density, lower susceptibility to noise and allows for the use of simpler sense amps for reading the cell. Furthermore, although PFETs inherently have a lower conductance and gain for a given size, a smaller and more efficient cell may be implemented in CMOS in accordance with the invention.

The use of PFETs as transfer gates offers the following circuit-related feature, in addition to the layout advantages discussed above: A PFET can pull all the way up to VDD, while an NFET can only pull up to VDD-VT, where VT represents the threshold voltage of the NFET (e.g., 1 volt). This means that if the BITA and NBITA lines are precharged to VDD-VT instead of VDD (precharging to VDD-VT is accomplished with an NFET precharge FET), the side of the cell at a low voltage will pull its bit line (BITB or NBITB) toward ground while the other side will pull its bit line toward VDD. As a result, the differential voltage sensed by the sense amp will change faster than would be the case if only the voltage of one of the bit lines were changing. This means that the present invention provides a way to make high density two-port RAM cells and arrays without the significant loss of speed that one would ordinarily expect from using PFET transfer gates.

Various modes of using the invention are envisioned, including NFET fast read port and/or fast write port and PFET fast read and/or slow write port; combinations of these uses will also be useful, depending upon the particular application involved. In addition, since both ports can be quickly read, a RAM array can be read at twice its normal maximum speed by simultaneously reading both ports at full speed and multiplexing the data into a single data stream. Other features and advantages are described below in connection with a detailed description of preferred embodiments.

### Brief Description of the Drawings

Figure 1 schematically depicts a prior art single-port RAM cell.

Figure 2 depicts the symbols used in this specification to respectively represent an NFET and a PFET.

Figure 3 schematically depicts a two-port RAM cell in accordance with the present invention.

Figures 4A-4D depict one preferred layout for the RAM cell of Figure 3.

### Detailed Description of Preferred Embodiments

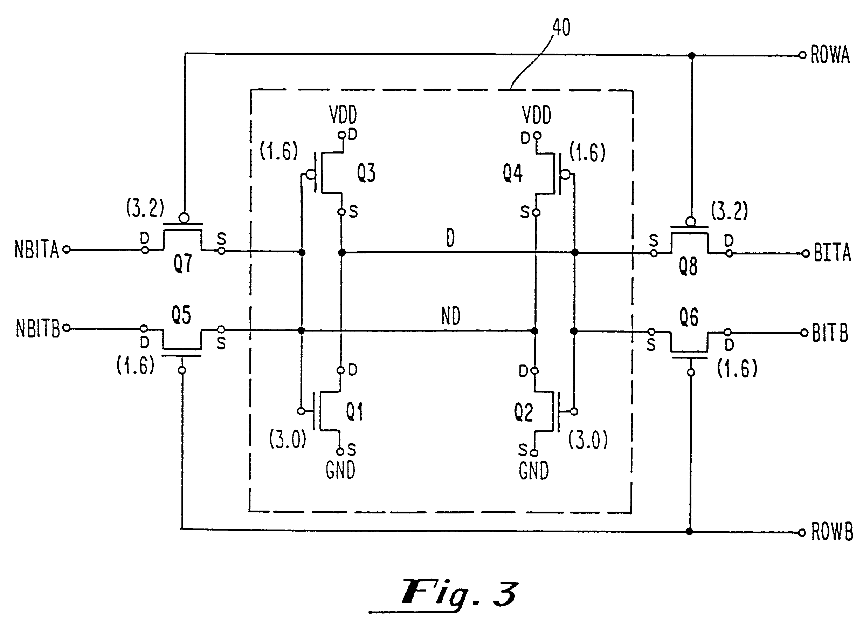

Figure 3 schematically depicts an example of a two-port RAM cell in accordance with the present invention. The data storage component 40 of the cell, enclosed within a dash line, comprises first and second NFETs Q1, Q2 connected as shown to first and second PFETs Q3, Q4. Each of the PFETs in this example has a gate width to gate length ratio of 1.6 and each of the NFETs Q1, Q2 has a gate width to gate length ratio of 3.0. In addition to the data storage component of the cell 40, the cell includes a first read/write port, comprising complementary terminals BITA and NBITA connected as shown to first and second transfer PFETs Q7, Q8, and a second read/write port comprising complementary terminals BITB and NBITB coupled as shown to first and second transfer NFETs Q5, Q6. The respective read/write ports are activated, or selected, via terminals ROWA and ROWB. Each of the first and second transfer PFETs Q7, Q8 in this example has a gate width to gate length ratio of 3.2 and each of the transfer NFETs Q5, Q6 has a gate width to gate length ratio of 1.6.

It should be noted that the FET sizes specified in this specification are only examples. The FET sizes should be chosen to meet the following goals:
1. minimize cell area,
2. meet system read timing requirements,
3. assure the cell is stable during a read (i.e., the cell is not accidentally flipped by a read or simultaneous reads),
4. assure the cell is writable (i.e., the cell can be flipped when desired, even with a simultaneous read to the other port).
These goals must be achieved over process, voltage and temperature variations. Different system constraints will cause the FET sizes to vary to meet the above goals.

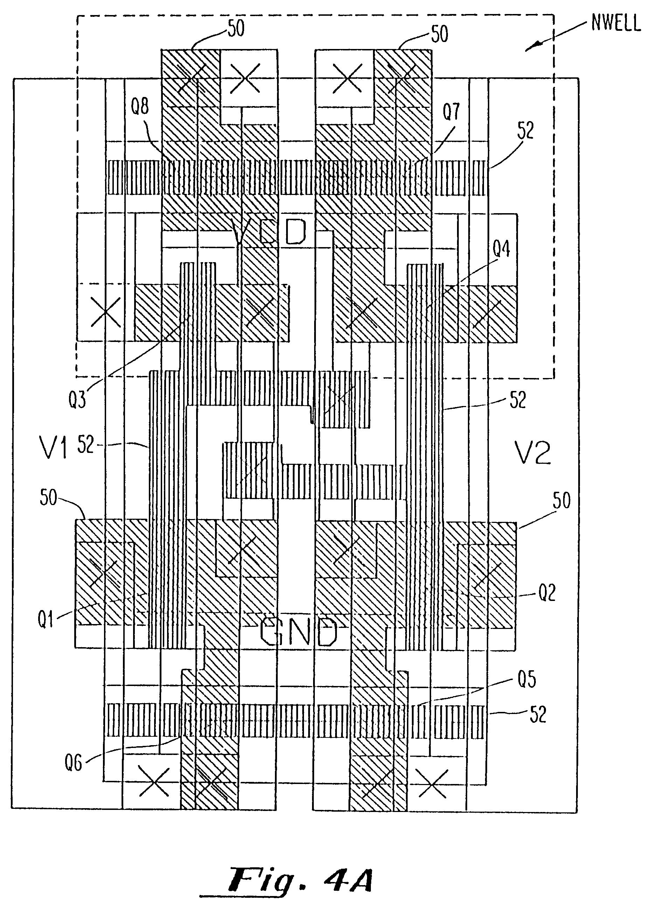

Figures 4A-4D depict one preferred layout for the RAM cell of Figure 3. The respective "colors", or shading patterns, of the different areas shown in Figures 4A-4D represent different layers with which the various components of the circuit are made. The symbols Q1 through Q8 are also used in Figure 4A to indicate the physical regions of the layout that correspond to the respective transistors.

Referring to Figure 4A, the areas labeled 50 correspond to the respective active areas of the devices (i.e., the source and drain areas of the transistors), the areas labeled 52 are composed of polysilicon and the areas in which the active areas 50 and polysilicon areas 52 overlap represent the respective gates of the transistors. In addition, the dash line around Q3, Q4, Q7 and Q8 encloses an "N-well" region, which is an area in which N-type material is diffused deep into the substrate. Each of the P-channel FETs Q3, Q4, Q7 and Q8 is formed in this N-well region. This is an optimal arrangement in the sense that it maximizes the number of devices occupying a given area of the substrate, minimizes the total capacitance of the cell and minimizes the power required to operate the cell. (If, for example, transfer FETs Q7 and Q8 were NFETs instead of PFETs, they would have to be placed outside of the N-well region and the cell would either have to be made larger or non-rectangular; this would also increase the complexity of the metal layers (described below) needed to interconnect the FETs.)

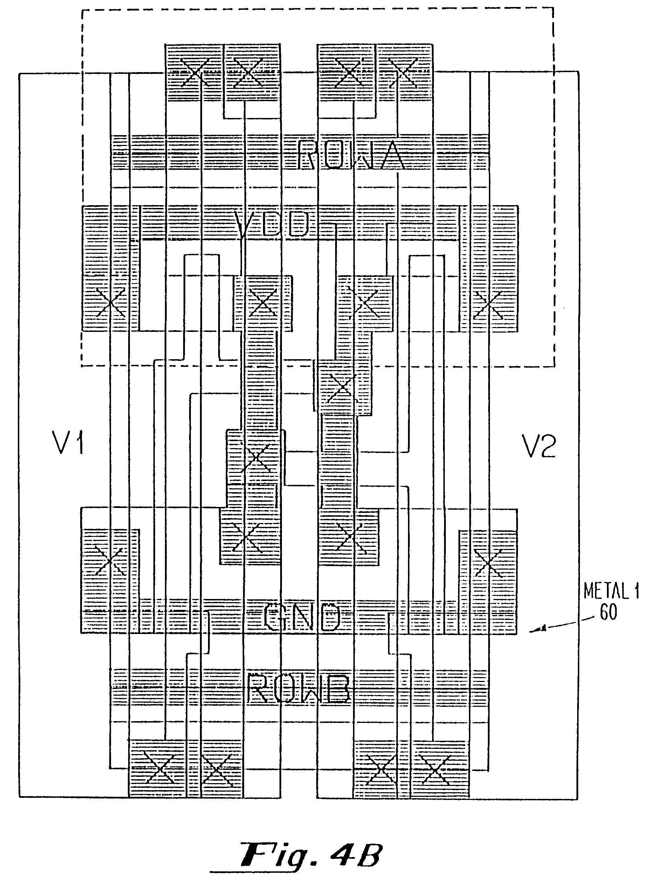

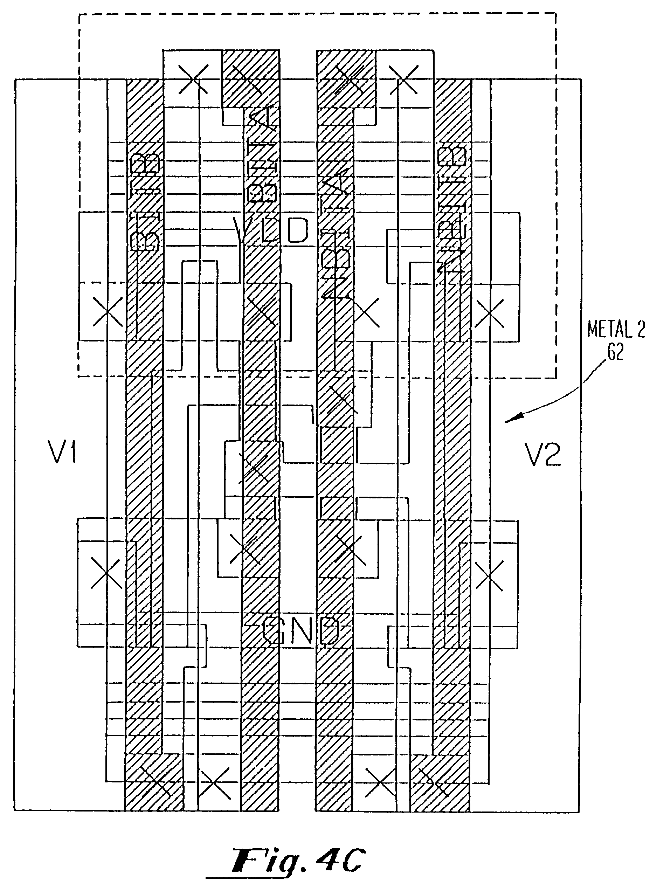

The regions labeled V1 and V2 each serve as a bus for providing a potential of either VDD (a predefined potential) or ground, depending on the particular cell within an array of such cells the region is in. It should also be noted that the "X" symbols in Figures 4A-D represent interlayer contacts, or vias, for interconnecting respective metal layers of the cell. These metal layers are shown in Figures 4B-4D.

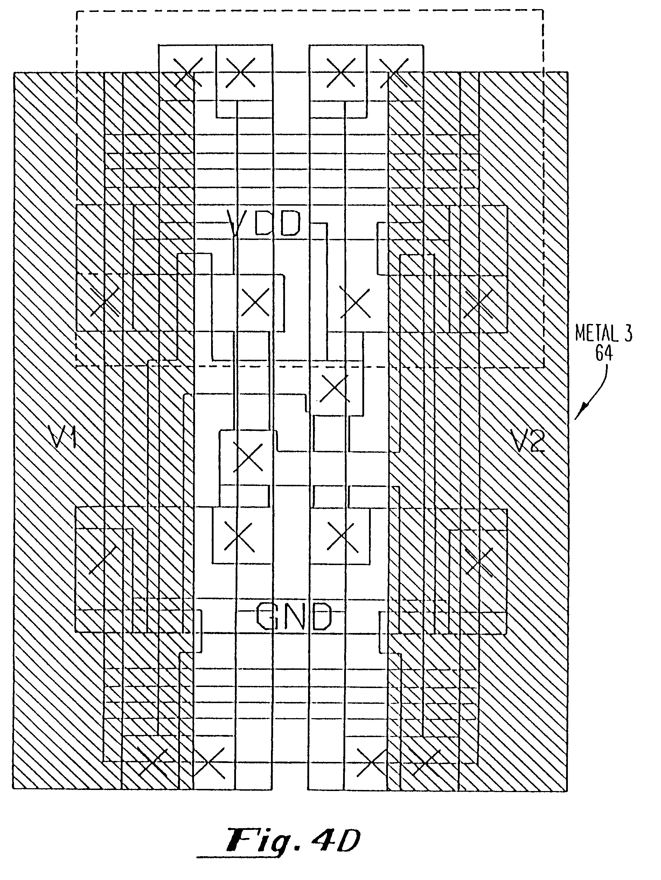

Referring now to Figures 4B-4D, the RAM cell also comprises three metal layers 60, 62 and 64 (also labeled as METAL1, METAL2 and METAL3). These metal layers provide means for interconnecting the FETs as shown in Figure 3. Metal layer 60 (METAL1) is represented by the shaded areas of Figure 4B; metal layer 62 (METAL2), shaded-in Figure 4C, provides the BITA, NBITA, BITB and NBITB conductors for the cell, and metal layer 64 (METAL3), shaded in Figure 4D, provides the above-mentioned V1, V2 conductors. Insulating layers (not shown) separate the metal layers. The further details involved in laying out a RAM cell or RAM array in accordance with the present invention will be apparent to those skilled in the art, given the information provided herein; therefore such further details will not be set forth in this specification.

One exemplary application of the present invention is in the context of a color map, implemented with a two-port RAM, for a computer graphics system. The color maps provide a means for remapping color data stored in a frame buffer to data representing other desired colors, on a per pixel basis. This function is realized in accordance with the present invention with a RAM that takes in 8-bits of address data and outputs 8-bits of data that becomes the input to a digital-to-analog convertor (DAC).

Color remapping must continue while the RAM is being updated with a new translation table. In a color map in accordance with the present invention, the new table data comes into the chip through a microprocessor interface and is asynchronous with the pixel timing. If the color map were implemented with a single-port RAM, one way to handle the above situation would be to synchronize the write data and then steal a pixel read cycle to write the new data. However, high-speed synchronization is a difficult circuit problem to solve and write errors (although infrequent) can still occur. During the write cycle, the pixel data to the DAC would have to come from some place other than the RAM. A color map in accordance with the present invention solves this problem by using the two-port RAM described above for the color maps. The first (and faster) of the two ports is dedicated to pixel reads, the second port is used for microprocessor writes to or reads from any RAM location, independent of the other ports' current address. Although the two-port RAM is larger than a single port version, it avoids the need to synchronize the two data flows, eliminating complex synchronizing circuits and potential synchronizer failure.

The foregoing description of exemplary, preferred embodiments is not intended to limit the scope of protection afforded by the following claims, which describe the true scope of the present invention.

## Claims

1. A two-port random access memory (RAM) cell formed in a substrate, comprising:
a data storage element comprising first and second N-channel field effect transistors (NFETs) (Q1, Q2) and first and second P-channel field effect transistors (PFETs) (Q3, Q4), said N- and PFETs each comprising a gate, drain and source;
a first differential read/write port comprising first and second transfer NFETs (Q5, Q6) formed in said substrate; and
a second differential read/write port comprising first and second transfer PFETs (Q7, Q8) formed in said substrate.

2. A two-port RAM cell as described in claim 1, further comprising:
first interconnecting means for interconnecting the gate of said first transfer PFET (Q7) and the gate of said second transfer PFET (Q8);
second interconnecting means for interconnecting the gate of said first transfer NFET (Q5) and the gate of said second transfer NFET (Q6);
third interconnecting means for interconnecting the source of said first transfer PFET (Q7), the gate of said first PFET (Q3), the gate of said first NFET (Q1), the source of said first transfer NFET (Q5), the source of said second PFET (Q4), and the drain of said second NFET (Q2); and
fourth interconnecting means for interconnecting the source of said second transfer PFET (Q8), the gate of said second PFET (Q4), the gate of said second NFET (Q2), the source of said second transfer NFET (Q6), the source of said first PFET (Q3), and the drain of said first NFET (Q1).

3. A two-port RAM cell as described in claim 1 or claim 2, further comprising an N-well of N-type material diffused into said substrate, wherein said first and second PFETs (Q3, Q4) and said first and second transfer PFETs (Q7, Q8) are formed in said N-well.

4. A two-port RAM cell as described in claim 2 or claim 3, comprising:
a first terminal (ROWA) connected to said first interconnecting means;
a second terminal (ROWB) connected to said second interconnecting means;
a third terminal (BITA) connected to the drain of said second transfer PFET (Q8);
a fourth terminal (NBITA) connected to the drain of said first transfer PFET (Q7);
a fifth terminal (BITB) connected to the drain of said second transfer NFET (Q6); and
a sixth terminal (NBITB) connected to the drain of said first transfer NFET (Q5);
whereby a binary digit (bit) may be written to said RAM cell by either:
setting said third terminal (BITA) to a high potential for a binary "1" or a low potential for a binary "0" while holding said first terminal (ROWA) and said second terminal (ROWB) to a low potential, or
setting said fifth terminal (BITB) to a high potential for a binary "1" or a low potential for a binary "0" while holding said first terminal (ROWA) and said second terminal (ROWB) to a high potential, and
a previously-written bit may read from the cell be by either:
precharging said third terminal (BITA) and said fourth terminal (NBITA) to a high potential, setting said first terminal (ROWA) to a low potential, and monitoring the difference in the potentials of said third and fourth terminals (BITA, NBITA), or
precharging said fifth terminal (BITB) and said sixth terminal (NBITB) to a high potential, setting said second terminal (ROWB) to a high potential, and monitoring the difference in the potentials of said fifth and sixth terminals (BITB, NBITB).

5. A two-port RAM cell as described in claim 2, 3 or 4, wherein said first and second NFETs (Q1, Q2) each have a gate width to gate length ratio of approximately 3.0, said first and second PFETs (Q3, Q4) each have a gate width to gate length ratio of approximately 1.6, said first and second transfer NFETs (Q5, Q6) each have a gate width to gate length ratio of approximately 1.6, and said first and second transfer PFETs (Q7, Q8) each have a gate width to gate length ratio of approximately 3.2.
